# EUROPEAN PATENT APPLICATION

(11) **EP 1 584 979 A1**
(43) Date of publication of application: **12.10.2005**
(21) Application number: 05004250.6
(22) Date of filing: 26.02.2005
(51) Int. Cl.: G03F 1/00, G03F 1/14, G03F 7/20

(54) **Mask blank having a protection layer**

(30) Priority: 08.04.2004 EP 04008566; 06.09.2004 WO PCT/EP20/04009919; 10.09.2004 US 608414 P
(71) Applicant: Schott AG, 55120 Mainz (DE)
(72) Inventor: Becker, Hans, Dr., 98617 Meinigen (DE); Buttgereit, Ute, 98544 Zella-Mehlis (DE); Hess, Günter, Dr., 98617 Meinigen (DE); Goetzberger, Oliver, Dr., 98617 Meinigen (DE); Schmidt, Frank, Dr., 07745 Jena (DE); Sobel, Frank, Dr., 44750 La Baule (FR); Renno, Markus, 98617 Meinigen (DE)

(57) **Abstract**

A mask blank and photomask for exposure light having a wavelength of 300 nm or less is described having an improved chemical durability in particular with respect to alkaline cleaning procedures. In particular, a mask blank and photomask comprise an additional ultra thin protection layer provided on a silicon and/or aluminium containing layer.

## Description

The present invention relates to mask blanks for exposure wavelength of less than 300 nm, a process for their preparation, and to photomasks manufactured by pattering of such mask blanks.

There is considerable interest in phase shift masks as a route to extending resolution, contrast and depth focus of lithographic tools beyond what is achievable with the normal binary mask technology.

Among the several phase shifting schemes, the (embedded) attenuating phase shift masks (also referred to as half tone phase shift masks) proposed by Burn J. Lin, Solid State Technology, January issue, page 43 (1992), the teaching of which is incorporated herein by reference, is gaining wider acceptance because of its ease of fabrication and the associated cost savings.

Besides the technical solution of the attenuating phase shift masks, alternating phase shift masks (also referred to as hard type or Levinson type phase shift masks) have also been proposed. In such alternating phase shift masks, the substrate is provided with a slightly transparent layer, e.g. a very thin chrome layer, coupled with etching into the quartz substrate to produce the desired phase shift.

Due to their optical properties and particular excellent transmission, silicon and/or aluminum containing layers are often employed at an exposure wavelengths of 300 nm or less, e.g. for binary mask blanks as well as for optically active layers in the phase shift system in both types of phase shift masks.

During the manufacturing process of mask blanks as well as during the patterning process of the photomasks, the thin film system of the mask blank and the photomask is exposed to various and repeated cleaning procedures often employing chemically rather aggressive cleaning agents. Whereas the chemical durability of silicon and/or aluminum containing layers against acids is satisfactory, such layers are prone to degradation when cleaned using alkaline agents. Thus, if a thin film system comprising layers containing silicon and/or aluminum as the topmost layer is cleaned using such alkaline cleaning agents, thin strata of the layer may be washed off thus reducing the thickness of such a silicon and/or aluminum containing layer. However, in particular if the silicon and/or aluminum containing layer imparts an optical property such as e.g. a phase shift and/or a specific transmission to the mask blank, such alkaline cleaning may influence the optical properties of the mask blank and therefore needs to be avoided. Nevertheless, alkaline cleanings have advantages regarding the effectiveness of cleaning compared to acidic cleanings and thin film systems stable regarding alkaline cleaning agents would be advantageous.

Therefore, it is an object of the present invention to provide mask blanks and photomasks that have an improved chemical durability, in particular with respect to alkaline cleaning procedures.

The present invention relates to a mask blank, comprising a substrate and a thin film system; said thin film system comprising at least one silicon and/or aluminum containing layer, wherein said silicon and/or aluminum containing layer comprises silicon and aluminum in an amount of at least 30 at. %; at least one protection layer provided on one or more silicon and/or aluminum containing layer(s); each protection layer protecting a silicon and/or aluminum containing layer; wherein said protection layer has a thickness of from 0.2 to 4 nm; said mask blank being able of producing a photomask at an exposure light having a wavelength of 300 nm or less.

It has been found that providing a protection or barrier layer according to the present invention prevents damage on in particular the surface of a silicon and/or aluminum containing layer by cleaning procedures such as e.g. during the manufacture of the mask blank or photomask.

As known in the art, a "photomask blank" or "mask blank" differs from a "photomask" or "mask" in that the latter term is used to describe a photomask blank after it has been structured or patterned or imaged. While every attempt has been made to follow this convention herein, those skilled in the art will appreciate the distinction in not a material aspect of this invention. Accordingly, it is to be understood that the term "photomask blank" or "mask blank" is used herein in the broadest sense to include both imaged and non-imaged photomask blanks.

According to the present invention, the expressions "under" and "on" when used to describe the relative position of a first layer to a second layer in the layer system of the mask blank have the following meaning: "under" means that said first layer is provided closer to the substrate of the mask blank than said second layer and the expression "on" means that said first layer is provided further remote from the substrate than said second layer.

Furthermore, if not explicitly mentioned otherwise, the expressions "under" or "on" can mean "directly under" as well as "under, but at least one further layer is provided in between said two layers" or "directly on" as well as "on, but at least one further layer is provided between said two layers".

The mask blank of the present invention comprises at least one silicon and/or aluminum containing layer, whereas said layer comprises silicon and aluminum in an amount of at least 30 at. %, i.e. the sum of silicon and aluminum in said layer amounts at least 30 at. %. The silicon and/or aluminum containing layer may either comprise only one of silicon or aluminum, or may comprise a mixture of silicon and aluminum. Besides silicon and/or aluminum, the silicon and/or aluminum containing layer may comprise further elements such as O, N, C, or B. Also other metals such as Ti, Zr, Hf, V, Nb, Ta, Cr, Mo, W, Y, La, Gd may be contained in the silicon and/or aluminum containing layer, however, only in an amount that is not sufficient to provide a protection of said layer against aggressive cleaning agents such as alkaline or acidic agents for the silicon and/or aluminum containing layer. Typically, such other metals are contained in the silicon and/or aluminum containing layer in an amount of at most 20 at. % and according to specific embodiments of at most 10 at. %. According to other embodiments of the present inventions, the silicon and/or oxygen containing layer comprises oxides, nitrides or oxy nitrides of silicon and/or aluminum. According to another embodiment of the present invention, the silicon containing layer comprises silicon, molybdenum and oxides, nitrides and oxy nitrides thereof.

The mask blank of the present invention comprises at least one protection layer that is provided on at least one silicon and/or oxygen containing layer. Thus, in case such silicon and/or aluminum containing layer is exposed to alkaline and/or acidic agents during the manufacture of the mask blank or the photomask, such protection layer will protect the silicon and/or aluminum containing layer from degradation.

A thin film system of a mask blank according to the present invention may comprise one protection layer on a silicon and/or aluminum containing layer or may comprise two or more protection layers wherein each of these protection layers is provided on a silicon and/or aluminum containing layer.

Preferably such a protection layer is provided directly on a silicon an/or aluminum containing layer.

According to certain embodiments of the present invention, said protection layer has a thickness of at most 4 nm, preferably at most 2 nm. In general, a thickness of at least 0.2 nm for the protection layer suffices to impart a protection function towards alkaline cleaning agents to the layer system, however, according to certain embodiments of the present invention, the protection layer has a thickness of at least 0.5 nm or even at least 0.7 nm, depending e.g. on the aggressiveness of the alkaline cleaning agent to be employed.

Preferably, the protection layer essentially does not substantially alter the optical properties of the mask blank and photomask, e.g. the protection layer may change the optical properties only to an amount of 2% or even 1 %. Optical properties are e.g. the phase shift, the transmission and the reflectivity properties of the mask blank.

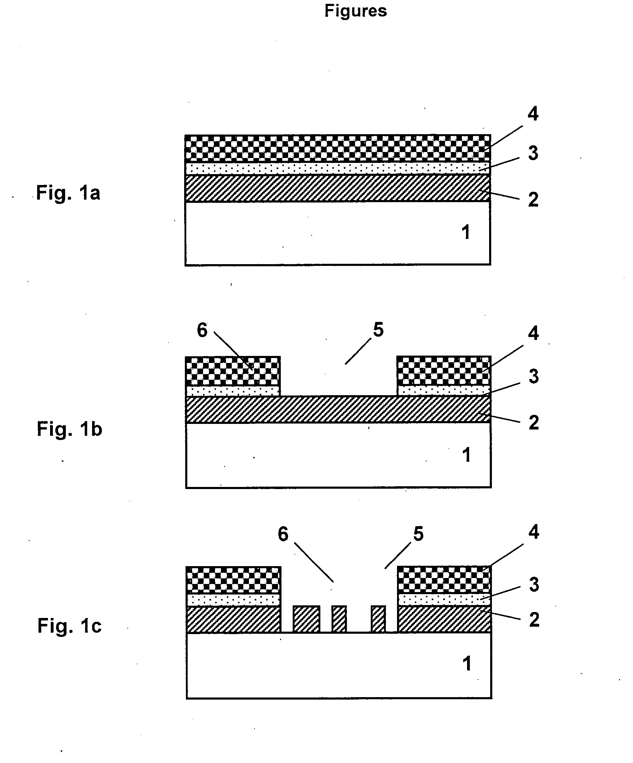

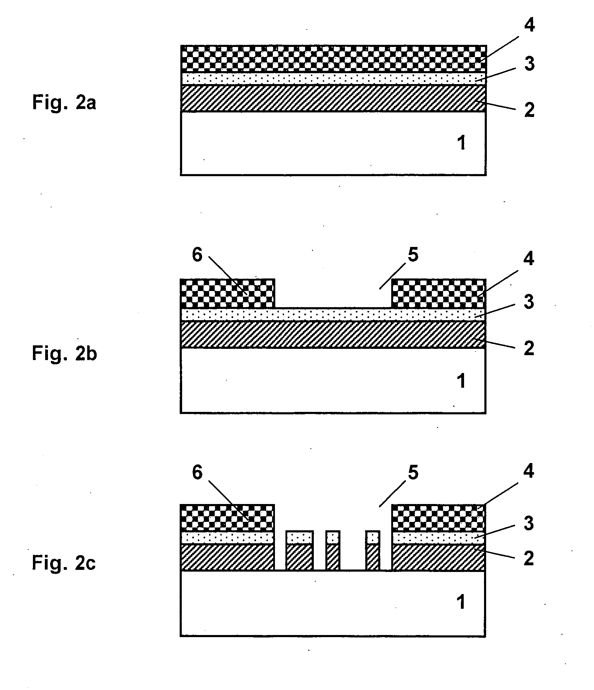

Figures 1 and 2 show two embodiments of the present invention. Figures 1 and 2 show schematic cross section of mask blanks (Fig. 1 a/2a) and a photomask (Fig. 1 c/2c) according to a first embodiment of the present invention. On the substrate 1, a silicon and/or aluminum containing layer 2, a protection layer 3 and an absorbing layer 4 are provided. The protection layer 3 may have an etching selectivity different to the silicon and/or aluminum containing layer 3 as shown in Figure 1. In this case during etching of the absorbing layer 4, also the protection layer is etched and a pattern comprising edges 6 and recesses 5 within the absorbing layer 4 and the protection layer 3 is provided. The protection layer 3 may also have the same etching selectivity as the silicon and/or aluminum containing layer 2 as shown in Figure 2 and an etching selectivity different from the absorbing layer 4.

The expression "different etching selectivity" means that a second layer provided under a first layer is not substantially etched, when the first layer provided on the second layer is etched using a first etching agent. In case the second layer has such a different etching selectivity, a second etching agent will generally be necessary to etch the second layer. The expression "same etching selectivity" means that a second layer provided under a first layer is substantially etched, when the first layer provided on the second layer is etched using a specific etching agent.

The protection layer preferably comprises a metal oxide or oxy nitride such as an oxide or oxy nitride of Ti, Zr, Hf, V, Nb, Ta, Cr, Mo, W, Y, La, Gd or mixtures thereof.

The mask blank of the present invention further may comprise a light absorbing layer in particular on top of the thin film system such as e.g. on the topmost protection layer. According to one embodiment of the present invention the light absorbing layer comprises at least one metal selected from the group consisting of Ti, Zr, Hf, V, Nb, Ta, Cr, Mo, W, Y, La, Gd and/or nitrides, carbides, oxy nitrides oxides or mixtures thereof. According to certain embodiments of the present invention, the light absorbing layer comprises at least 80% of TaN or Cr.

The mask blank of the present invention may additionally comprise further layers such as e.g. one or more of an antistatic layer, an antireflection layer, an etch stop layer, etc.

According to one embodiment of the present invention, one or more layers of the mask blank of the present invention may have a gradual change of the composition in different distances from the substrate.

According to one embodiment of the present invention, the phase shift system has a thickness of at most 350 nm, preferably of at most 300 nm.

According to one aspect of the present invention, the mask blank of the present invention is a phase shift mask blank having a phase shift of substantially 180°. The expression "having a phase shift of substantially 180°" means that the phase shift mask blank provides a phase shift of the incident light sufficient to cancel out light in the boundary section of a structure and thus to increase the contrast at the boundary. According to certain embodiments of the present invention, a phase shift of 160° to 190°, preferably of 170° to 185° is provided.

A phase shift mask blank according to this embodiment of the present invention has a transmission of at least 0.001 %, preferably of at least 0.5 %, at an exposure light having a wavelength of 300 nm or less.

Such phase shift mask blank may be an attenuated phase shift mask blank or an alternating mask blank or a mask blank as described in international patent application PCT/EP2004/00919 and U.S. patent application serial no. 10/655,593, the content of which is incorporated herein by reference, i.e. embedded attenuated phase shift photo mask blanks, wherein the mask blank comprises a substrate and a thin film system, said thin film system comprising
- a transmission control sublayer comprising a metal and/or metal compound selected from the group consisting of Mg, Y, La, Ti, Zr, Hf, V, Nb, Ta, Cr, Mo, W, Mn, Fe, Co, Ni, Zn, Ge, Sn, Pb, wherein Ta, Ti, Hf, Mo, W are preferred, oxides, nitrides, borides and carbides thereof and combinations of metals and compounds thereof, preferably in an amount of at least 95 at.-%;
- a phase shift control sublayer comprising borides, carbides, oxides and/or nitrides of Ge, Si and/or Al or combinations thereof, preferably in an amount of at least 95 at.-%.;
and wherein said mask blank being able of producing a photomask with substantially 180° phase shift and an optical transmission of at least 0.001% at an exposure light having a wavelength of 300 nm or less. Preferably the mask blank has a transmission of from 5 % to 30 % at a wavelength of 157 nm, 193 nm, or 248 nm.

An attenuated phase shift mask blank generally comprises a phase shift system that imposes a phase shift function to the mask blank. Such phase shift system may be a monolayer phase shift system, a bilayer phase shift system or a multiplayer phase shift system. Examples of attenuated phase shift mask blanks employing such mono, bi and multilayer phase shift systems are described in U.S. patent application No. 10/655,593, EP application number 04 001359, US 5,482,799, US 6,458,496, US 6,274,280, US 5,897,977, US 5,474,864 and US 5,482,799, whereas the content of these documents is incorporated herein by reference. E.g. bilayer phase shift mask blanks as mentioned above and monolayer phase shift mask blanks comprising a substrate transmitting exposure light and at least one phase shift layer on said substrate comprising carbides, borides, oxides, oxynitrides and/or nitrides of molybdenum silicide, preferably oxides, oxynitrides and/or nitrides of molybdenum silicide.

The present invention furthermore relates to a method of manufacturing mask blank comprising a substrate and a thin film system; said thin film system comprising a silicon and/or aluminum containing layer, wherein said silicon and/or aluminum containing layer comprises silicon and aluminum in an amount of at least 30 at. %; a protection layer provided on said silicon containing layer and having a thickness of from 0.2 to 4 nm; said mask blank being able of producing a photomask at an exposure light having a wavelength of 300 nm or less; said method comprising the steps of:
providing a substrate;
providing a thin film system on said substrate; and
cleaning said thin film system.

According to one embodiment of the present invention a further layer is provided on the thin film system after the thin film system the thin film system has been cleaned. Such further layer may be one or more layers such as an absorbing layer and/or one or more anti reflection layers. Alternatively, after such a cleaning operation, a photoresist may be provided on the mask blank.

Preferably, the cleaning of said thin film system is performed using an alkaline cleaning agent, such as e.g. an in particular aqueous solution of KHO, NaOH, or ammonia. The cleaning may be supported by elevated temperatures, such as e.g. at 50°C and/or an ultra or mega sonic treatment, ozone treatment and/or UV irradiation.

Preferably, the phase shift system and or one or more further layers of the thin film system are formed by sputter deposition using a technique selected from the group consisting of dual ion beam sputtering, ion beam assisted deposition, ion beam sputter deposition, RF matching network, DC magnetron, AC magnetron, and RF diode.

According to an embodiment, e.g. a phase shift system and/or optional further layers are deposited in a single chamber of deposition apparatus without interrupting the ultra high vacuum. It is particularly preferred to deposit the silicon and/or aluminum containing layer and the protection layer without interrupting the vacuum. Thus, decontamination of the mask blank with surface defects can be avoided and a mask blank substantially free of defects can be achieved. Such a sputtering technique can e.g. be realized by using a sputter tool that allows sputtering from several targets. Thus, high quality masks having a low defect density and/or highly uniform layers with respect to the thickness of the layers can be achieved.

As the sputtering targets, targets comprising elements or targets comprising components can be used. In case the deposited layer contains an oxide, nitride or oxy nitride of a metal or semimetal, it is possible to use such oxide, nitride or oxy nitride of a metal or semimetal as the target material. However, it is also possible to use a target of a metal or semimetal and to introduce oxygen and/or nitrogen as an active sputtering gas. In case of the deposition of SiO₂, it is preferred to use a target of Si and to introduce oxygen as an active gas. In case the deposited layer shall comprise nitrogen, it is preferred to introduce nitrogen as an active sputtering gas.

For the sputtering gas, it is preferred to use inactive gasses such as helium, argon or xenon. Such inactive gasses can be combined with active gasses such as oxygen, nitrogen, nitrogen monoxide, nitrogen dioxide, and dinitrogen oxide or mixtures thereof. Active gasses are gasses that may react with sputtered ions and thus become part of the deposited layer.

Furthermore, the present invention relates to a photomask for lithography at an exposure light having a wavelength of 300 nm or less, comprising a substrate and a thin film system; said thin film system comprising
at least one silicon and/or aluminum containing layer, wherein said silicon and/or aluminum containing layer comprises silicon and aluminum in an amount of at least 30 at. %;
a protection layer provided on said silicon containing layer and having a thickness of from 0.2 to 4 nm; and
a light absorbing layer provided on the protection layer.

Specific embodiments of the photomask of the present invention may have the same composition and structure as described for the mask blank according to the present invention as described above.

The present invention also relates to a method of making a photomask for lithography at an exposure light having a wavelength of 300 nm or less, comprising a substrate and a thin film system; said thin film system comprising at least one silicon and/or aluminum containing layer, wherein said silicon and/or aluminum containing layer comprises silicon and aluminum in an amount of at least 30 at. %; a protection layer provided on said silicon containing layer having a thickness of from 0.2 to 4 nm; and a light absorbing layer provided on the protection layer, wherein said method comprises the step of cleaning the thin film system.

As an etching process, a dry etching method using a chlorine-based gas such as Cl₂, Cl₂+O₂, CCl₄, CH₂Cl₂, or a wet etching using acid, alkali or the like may be used. However, a dry etching method is preferred. Also possible are etching methods using a fluorine containing component, reactive ion etching (RIE) using fluorine gasses such as CHF₃, CF₄, SF₆, C₂F₆ and mixtures thereof is preferred. In general, at least two different etching methods and/or agents are employed when etching the mask blanks of the present invention.

According to one embodiment of this aspect of the present invention, the cleaning of said thin film system is performed using an alkaline cleaning agent as described above for the cleaning for the manufacture of the mask blank.

### Examples

In the following, the design and fabrication of mask blanks according to a preferred embodiment of the present invention are described.

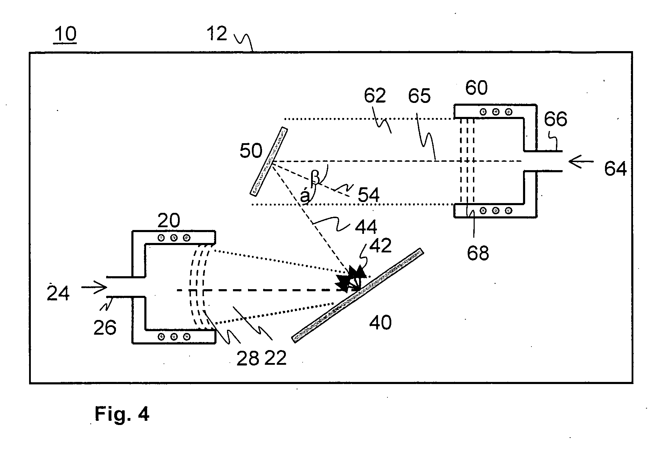

All layers were deposited using a dual ion beam sputtering tool as schematically shown in Figure 4. In particular, a Veeco Nexus LDD Ion Beam Deposition Tool was used for all depositions. The exact deposition parameters were determined by DOE using as software JMP, release 5.0. 1a, by SAS Institute Inc., SAS Campus Drive, Cary, North Carolina 27513, USA.

Table A shows general deposition parameters for the sputtering of the materials used according to the Examples and Comparative Examples:

**Table A:**

| General deposition parameters | | | | | |
|---|---|---|---|---|---|
| | Ta | SiO₂ | Al₂O₃ | Ta₂O₅ | Cr₂O₃ |
| Deposition Source | | | | | |
| Gas flow [sccm] | 10 | 10 | 10 | 10 | 10 |
| Sputter Gas | Ar | Ar | Ar | Ar | Ar |
| | | | | | |

| Assist Source | | | | | |
|---|---|---|---|---|---|
| Sputter Gas | -- | O₂ | O₂ | O₂ | O₂ |
| | | | | | |

| Other | | | | | |
|---|---|---|---|---|---|
| Target material | Ta | Si | Al | Ta | Cr |
| Deposition rate [Å/s] | 1.20 | 0.29 | 0.32 | 0.57 | 0.85 |
| Background pressure [×10⁻⁸ Torr] | < 3 | < 3 | < 3 | < 3 | < 3 |
| Deposition pressure [×10⁻⁴ Torr] | ~ 2 | ~ 2 | ~ 2 | ~ 2 | ~ 2 |

Two layer phase shift systems as described in US patent application Serial No. 10/655,593 comprising Ta (20 nm) as the transmission control layer and SiO₂ as the phase shift control layer (106 nm) are sputtered on a quartz substrate using the sputtering parameters as described in Table A.

On the phase shift systems of the Examples according to this invention, a protection layer as described in Table B is provided using the sputtering conditions as described in Table A.

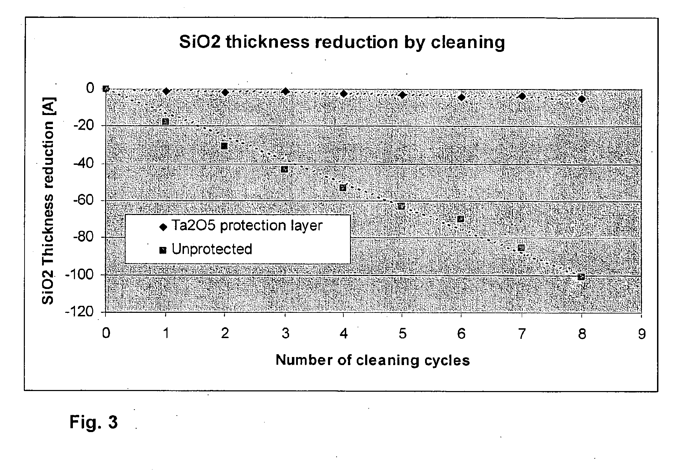

Then, the phase shift systems according to the Examples and the Comparative Examples are dipped in alkaline cleaning solutions for several cycles. The impact of this cleaning on the silicon containing layer is also shown in Table B. The thickness reduction of the SiO₂ layer of the phase shift system of Example 1 and Comparative Example 1 is further shown in Figure 3.

**Table B**

| | Com.-Ex. 1 | Example 1 | Example 2 | Example 3 |
|---|---|---|---|---|
| Protection layer | none | Ta₂O₅ | Ta₂O₅ | Cr₂O₃ |
| Thickness of protection layer | -- | 0.5 nm | 1 nm | 1 nm |
| thickness loss of SiO₂ layer per cleaning cycle (KOH (50-250ppm), pH 12 at 50°C) | 1.2 nm | none | none | none |

As shown in Table B, the layer systems protected by a protection layer according to the present invention are stable even towards a strong alkaline cleaning solution and even at elevated temperatures.

Furthermore, phase shift and transmission of the phase shift system are not altered by the additional protection layer on the phase shift system.

The experiments are repeated using Al₂O₃ instead of SiO₂ in the phase shift system. The Al₂O₃ layer not covered by a protection layer according to the present invention shows even greater loss of thickness during the cleaning process. Al₂O₃ layers covered by a protection layer according to the present invention, are not ablated during the cleaning with the alkaline cleaning agent.

After the cleaning procedure with an alkaline cleaning agent, an absorbing layer (Cr, 60 nm) was provided on the phase shift system to result in a phase shift mask blank. nm). The mask blank then was submitted to the chromium dry etch process (Cl + O₂).

Grazing incidence X-ray reflection curves (GIXR) and spectral curves (n&k) of the mask blank before deposition of Cr and after removal of Cr are the same. This result shows that the thin Ta₂O₅ protection layer is not removed by the chromium dry etch process.

## Claims

1. A mask blank, comprising a substrate and a thin film system;
said thin film system comprising
a silicon and/or aluminum containing layer, wherein said silicon and/or aluminum containing layer comprises silicon and aluminum in an amount of at least 30 at. %;
a protection layer provided on said silicon containing layer and having a thickness of from 0.2 to 4 nm;
said mask blank being able of producing a photomask at an exposure light having a wavelength of 300 nm or less.

2. The mask blank according to claim 1, wherein the mask blank is a phase shift mask blank.

3. The mask blank according to claims 1 or 2, wherein said silicon and/or aluminum containing layer provides a phase shift to the mask blank.

4. The mask blank according to any one of the preceding claims, wherein the protection layer and the silicon and/or aluminum containing layer have the same etch selectivity.

5. The mask blank according to any one of the preceding claims, wherein said protection layer comprises at least one oxide or oxy nitride of a metal selected from the group consisting of Ti, Zr, Hf, V, Nb, Ta, Cr, Mo, W, Y, La, Gd or mixtures thereof.

6. A method of manufacturing a mask blank according to any one of claims 1 to 5, said method comprising the steps of:
- providing a substrate;
- providing a thin film system on said substrate; and
- cleaning said thin film system.

7. The method according to claim 6, wherein after cleaning of the thin film system, a further layer is provided on the thin film system.

8. The method according to claim 7, wherein as such further layer an absorbing layer is provided.

9. The method according to claim 6, wherein the cleaning of said thin film system is performed using an alkaline cleaning agent.

10. The method according to claim 6, wherein at least one layer of said thin film system is provided by using an ion beam sputtering process.

11. A photomask for lithography at an exposure light having a wavelength of 300 nm or less, comprising a substrate and a thin film system;
said thin film system comprising
at least one silicon and/or aluminum containing layer, wherein said silicon and/or aluminum containing layer comprises silicon and aluminum in an amount of at least 30 at. %;
a protection layer provided on said silicon containing layer and having a thickness of from 0.2 to 4 nm; and
a light absorbing layer provided on the protection layer.

12. A method of making a photomask according to claim 11, wherein said method comprises the step of cleaning the thin film system.

13. The method according to claim 12, wherein the cleaning of said thin film system is performed using an alkaline cleaning agent.
